# EUROPEAN PATENT SPECIFICATION

(11) **EP 3 299 802 B1**
(45) Date of publication and mention of the grant of the patent: **18.03.2020**
(21) Application number: 15892994.3
(22) Date of filing: 18.06.2015
(51) Int. Cl.: H01J 37/20

(54) **CHIP ASSEMBLY FOR MEASURING ELECTROCHEMICAL REACTION ON SOLID-LIQUID PHASE INTERFACE IN SITU**
CHIPANORDNUNG ZUR IN-SITU-MESSUNG EINER ELEKTROCHEMISCHEN REAKTION AUF EINER FEST-FLÜSSIG-PHASENSCHNITTSTELLE
ENSEMBLE PUCE DESTINÉ À MESURER IN SITU UNE RÉACTION ÉLECTROCHIMIQUE SUR UNE INTERFACE DE PHASE SOLIDE-LIQUIDE

(30) Priority: 22.05.2015 CN 201510267214
(43) Date of publication of application: 28.03.2018
(73) Proprietor: Suzhou Institute of Nano-tech and Nano-bionics (SINANO) Chinese Academy of Sciences, Suzhou, Jiangsu 215125 (CN)
(72) Inventor: ZHANG, Yuegang, Suzhou Jiangsu 215125 (CN); RONG, Genlan, Suzhou Jiangsu 215125 (CN); MA, Shuo, Suzhou Jiangsu 215125 (CN)
(74) Representative: Cabinet Laurent & Charras
(86) International application number: PCT/CN2015/081852
(87) International publication number: WO 2016/187913

(56) References cited:
- EP-A1- 2 316 565
- WO-A2-2012/018827
- WO-A2-2014/160061
- CN-A- 103 411 982
- JP-A- 2008 047 411
- US-A1- 2009 166 536
- US-B2- 8 891 728

## Description

### Technical field

The present disclosure belongs to the technical field of scanning electron microscopy test devices, and more particularly, relates to a chip assembly for *in-situ* observation of an electrochemical reaction on a solid-liquid interface.

### Background art

The study of solid-liquid interface, because of its importance in biology, chemistry and interface sciences, has always been a hotspot of scientific research worldwide. In recent years, with the rise of nano-material science, more and more research results show that the nanostructure of a material has a critical effect on its properties. Scanning electron microscope (SEM) as a powerful tool for characterizing the surface structure of a material can be used to obtain the information such as high resolution nanostructure, surface morphology change of a sample and energy spectrum of a chemical element through analysis. Moreover, the requirement of SEM on the size of a liquid chip/cell is much lower than that of transmission electron microscope (TEM). The chip size is not limited, facilitating the observation of morphology change of the sample.

The current SEM solid-liquid interface test methods make use of the specially-made sample-holder-matched liquid chip/cell. Generally, two chips are packaged by use of an epoxy resin, wherein one chip provides a groove with four edges for holding the to-be-tested liquid, the other chip provides a silicon nitride membrane window, and then electrodes are made on the two chips through a micro fabrication process to achieve *in-situ* electrochemical test on solid-liquid interfaces in a SEM. However, there are two major drawbacks for the existing *in-situ* SEM electrochemical testing chip/cell: (1) the cost is very high; the customers who use this technology need to buy a specially-made sample holder which costs at least 100,000 RMBs or more, thereby greatly limiting the application of this technology; (2) the requirements on the microfabrication processing of the liquid chip/cell are very high; since this technology makes use of a specially-made sample holder to hold the liquid chip/cell, it is required that the size and the structure of the liquid chip/cell match with the sample holder. Documents US8891728B2 and JP2008047411A both disclose chip assemblies for the observation of samples in liquids, document US2009166536A1 discloses a sample holder used in SEM or TEM permitting observation and inspection at higher resolution, and document EP2316565A1 relates to a micro-reactor for observing small particles, cells, bacteria, viruses or protein molecules in a fluid.

### Summary

In order to solve the above-mentioned problems of the related technics, the present disclosure provides a chip assembly for *in-situ* observation of an electrochemical reaction on a solid-liquid according to claim 1, which can be applied to the conventional SEM sample stage without the use of a specially-made sample holder, thereby significantly reducing the cost.

To achieve the above object of the present disclosure, the present disclosure adopts the following technical solution: A chip assembly for *in-situ* observation of an electrochemical reaction on a solid-liquid interface comprises a first electrode, a second electrode, a first insulating film, a second insulating film, a third insulating film, a fourth insulating film as well as a top chip and a bottom chip which are oppositely arranged and of which two sides are correspondingly combined in a sealing manner; wherein the top chip has a through hole, the first insulating film covers the inner surface of the top chip and the opening of the through hole on the inner surface of the top chip, and the second insulating film covers the outer surface of the top chip; the first electrode is disposed on the surface of the first insulating film towards the bottom chip and located under the through hole; a part of the inner surface of the bottom chip is recessed to form a groove opposite to the through hole, the third insulating film covers the inner surface and the outer surface of the bottom chip, the fourth insulating film covers the inner wall of the groove and the third insulating film on the inner surface of the bottom chip; and the second electrode is disposed on the fourth insulating film and located on one side of the groove.

Further, the size of the through hole is gradually increasing in a direction away from the inner surface of the top chip.

Further, the first electrode has a grid structure.

Further, the size of the first electrode matches with the opening of the through hole on the inner surface of the top chip.

Further, the first electrode extends towards the side end of the top chip to form a first electrode extending portion.

Further, the chip assembly further comprises a first adhesive member and a second adhesive member, the first adhesive member being disposed between the second electrode and the first insulating film opposite to the second electrode, and the second adhesive member being disposed between the first electrode extending portion and the fourth insulating film opposite to the first electrode extending portion.

Further, the first adhesive member and/or the second adhesive member are adhesives formed of epoxy resin.

Further, the first insulating film and/or the second insulating film and/or the third insulating film and/or the fourth insulating film are formed of silicon nitride.

Further, the material of the first electrode and/or the second electrode is a conductive metal.

Further, the sizes of the top chip and the bottom chip are from 1.5 cm × 2 cm to 2 cm × 3 cm.

By making a large-size top chip and bottom chip with size in a range from 1.5 cm × 2 cm to 2 cm × 3 cm, and making a first electrode and a second electrode through micro-processing on the top chip and bottom chip, respectively, the present disclosure provides a chip assembly which can be applied to the conventional SEM sample stage, thereby eliminating the need for a specially-made sample holder and greatly reducing the test cost (reducing from tens of thousands RMBs to a few thousand RMBs); meanwhile, the first electrode has a grid structure, which is beneficial for observing morphology change of the to-be-tested sample at the edge of the grid structure. Therefore, the chip assembly for *in-situ* observation of an electrochemical reaction on a solid-liquid interface according to the present disclosure not only significantly reduces the test costs, but also is beneficial for observing the change of the to-be-tested sample.

### Brief Description of the Drawings

The foregoing and other aspects, features and advantages of the embodiments of the present disclosure will become more apparent from the following description taken in conjunction with the accompanying drawings, in which in the drawings:
Figure 1 is a cross-sectional view of a chip assembly for *in-situ* observation of an electrochemical reaction on a solid-liquid interface according to an embodiment of the present disclosure;
Figure 2 is a top view of a first electrode according to an embodiment of the present disclosure.

### Detailed Description

Hereinafter, embodiments of the present disclosure will be described in detail with reference to the accompanying drawings. However, the present disclosure can be implemented in many different ways and the present disclosure should not be construed as being limited to the specific embodiments set forth herein. Rather, these embodiments are merely provided to explain the principles and its practical applications of the present disclosure so as to enable others skilled in the art to understand the various embodiments of the present disclosure and various modifications that are suitable for a particular intended application. In the drawings, for the sake of clarity, the shape and size of the elements can be exaggerated, and the same reference numerals will always be used to denote the same or similar elements.

It will be understood that although the terms "first" and "second" and the like can be used herein to describe various elements, these elements should not be limited by these terms which are used only to distinguish one element from another.

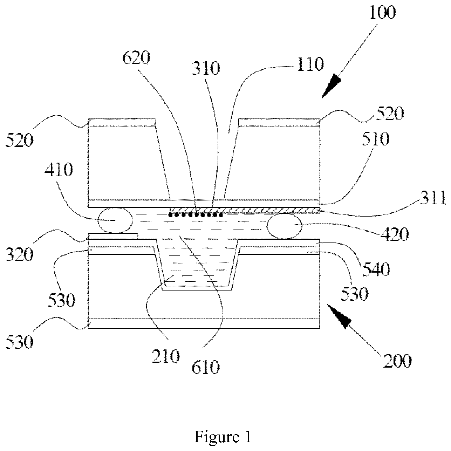

Figure 1 is a cross-sectional view of a chip assembly for *in-situ* observation of an electrochemical reaction on a solid-liquid interface according to an embodiment of the present disclosure.

Referring to Figure 1, the chip assembly for *in-situ* observation of an electrochemical reaction on a solid-liquid interface according to an embodiment of the present disclosure comprise a top chip 100, a bottom chip 200, a first electrode 310, a second electrode 320, a first adhesive member 410, a second adhesive member 420, a first insulating film 510, a second insulating film 520, a third insulating film 530, and a fourth insulating film 540; wherein the top chip 100 and the bottom chip 200 are oppositely arranged, and two sides of the top chip 100 and the bottom chip 200 are correspondingly combined in a sealing manner by the first adhesive member 410 and the second adhesive member 420, respectively.

In this embodiment, the top chip 100 and the bottom chip 200 are made of a Si wafer having a size about 2 cm × 3 cm and a thickness of 200 µm. The material of the first adhesive member 410 and the second adhesive member 420 is epoxy resin; wherein, the thickness of the top chip 100 and the bottom chip 200 is not particularly limited and is generally controlled within a range of 200 µm-500 µm depending on the thickness of the specifically selected Si wafer. The distance between the top chip 100 and the bottom chip 200 is also not particularly limited and depends on the amount of the epoxy resin used when bonding. However, the present disclosure is not limited thereto, and the size of the top chip 100 and the bottom chip 200 are generally controlled within a range from 1.5 cm × 2 cm to 2 cm × 3 cm to satisfy the requirements of the present disclosure.

In this way, an enclosed cavity is composed of the top chip 100, the bottom chip 200, the first adhesive member 410 and the second adhesive member 420, which can then be used to immobilize the to-be-tested liquid 610 when *in-situ* observation of the electrochemical reaction on solid-liquid interfaces.

Specifically, the top chip 100 has a through hole 110 throughout the top chip 100, and the size of the through hole 110 is gradually increasing in a direction away from the inner surface of the top chip 100; that is, the through hole 110 is essentially a groove with four edges, and its cross-sectional shape is an inverted trapezoid.

The opening of the through hole 110 towards the bottom chip 200 and the inner surface of the top chip 100 are covered with a first insulating film 510, in this way, the through hole 110 and the first insulating film 510 covering the opening thereof form a viewing window when *in-situ* observation is performed; while the outer surface of the top chip 100 is covered with a second insulating film 520. Meanwhile, the first electrode 310 is located under the through hole 110 and is disposed on the surface of the first insulating film 510 towards the bottom wafer 200, and the first electrode 310 also extends towards the side end of the top chip 100 to form a first electrode extending portion 311.

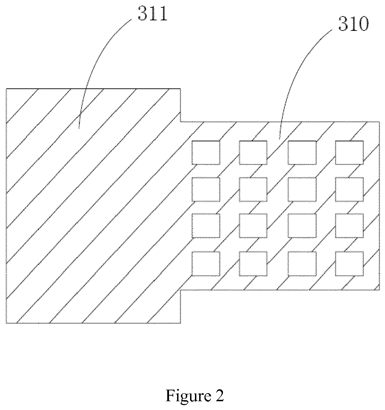

More specifically, the size of the first electrode 310 corresponds to the size of the opening of the through hole 110 on the inner surface of the top chip 100, and the first electrode 310 also has a grid structure, as shown in Figure 2; when the *in-situ* SEM observation of the electrochemical reaction on a solid-liquid phase interface is performed, the to-be-tested solid sample 620 is placed to the grid structure where the to-be-tested solid sample 620 thus contacts with the to-be-tested liquid 610 in the enclosed cavity and reacts. It is convenient to observe the morphology change of the to-be-tested solid sample 620 occurring in the to-be-tested liquid 610 due to such grid structure.

The bottom chip 200 comprises a groove 210 opposite to the through hole 110 formed by recessing a part of the inner surface. The groove 210 in this embodiment also presents a shape of a groove with four edges; of course, the shape of the through hole 110 and the shape of the groove 210 are not changeless, and they can have other shapes with similar functions, for example, the groove 210 can also have other irregular shapes.

It is similar to the construction of the top chip 100 that the inner surface of the bottom chip 200 located on both sides of the groove 210 and the outer surface of the bottom chip 200 are covered with a third insulating film 530, while the inner wall of the groove 210 and the third insulating film 530 on the inner surface of the bottom chip 200 are covered with a fourth insulating film 540; and the second electrode 320 is directly disposed on the fourth insulating film 530 located on one side of the groove 210; that is, the inner surface of the bottom chip 200 is covered with a third insulating film 530 and a fourth insulating film 540 sequentially.

Preferably, the material of the first insulating film 510, the second insulating film 520, the third insulating film 530 and the fourth insulating film 540 is a low stress silicon nitride membrane, and the stress of the low stress silicon nitride membrane is about 250 MPa. In this embodiment, the thicknesses of the first insulating film 510 and the second insulating film 520 are both 50 nm, and the thicknesses of the third insulating film 530 and the fourth insulating film 540 are both 50 nm. Of course, the present disclosure is not limited thereto, as long as the stress of the low stress silicon nitride membrane used as the first insulating film 510, the second insulating film 520, the third insulating film 530 and the fourth insulating film 540 is controlled to be not more than 250 MPa, and the thicknesses of the first insulating film 510 and the second insulating film 520 located on the top chip 100 is controlled within a range of 50 nm-80 nm, and the thickness of the third insulating film 530 and the fourth insulating film 540 located on the bottom chip 200 is controlled within a range of 50 nm-200 nm.

In this embodiment, the first adhesive member 410 is disposed between the second electrode 320 and the first insulating film 510 opposite thereto, and the second adhesive member 420 is disposed between the first electrode extending portion 311 and the fourth insulating film 540 opposite thereto.

Further, the first adhesive member 410 and the second adhesive member 420 are both adhesives formed of epoxy resin. Of course, other adhesives which can achieve the corresponding combination in a sealing manner of both sides of the top chip 100 and the bottom chip 200 can also be used, and this technology is a common practice for those skilled in the art and will not be repeated any more here.

In this embodiment, it is preferable that the first electrode 310 is an Au electrode and the second electrode 320 is a Cu electrode. It is worth noting that both the first electrode 310 and the second electrode 320 are immersed in the to-be-tested liquid 610, and the to-be-tested solid sample 620 is carried on the first electrode 310, and therefore it is required that neither the first electrode 310 nor the second electrode 320 will react with the to-be-tested liquid 610 and the to-be-tested solid 620. Of course, the first electrode 310 and the second electrode 320 are generally guided out through a conventional SEM hot stage and used for the electrochemical test, thus it is only required that they have conductive properties, that is, in the present disclosure, the first electrode 310 and the second electrode 320 can be formed of other suitable types of conductive metal or other suitable types of conductive materials, the specific selection depends on the types of the to-be-tested liquid sample 610 and the to-be-tested solid sample 620 in the actual operation.

The preparation process of the chip assembly which is suitable for *in-situ* SEM observation of an electrochemical reaction on a solid-liquid interface is as follows:
First, the preparation of the top chip 100 specifically adopts the following method.
(1) A Si wafer having a thickness of 200 µm was selected as the material of the top chip 100 and a silicon nitride membrane (the stress of the silicon nitride membrane was about 250 MPa) with a thickness of 50 nm was grown on the opposite two sides of the Si wafer by chemical vapor deposition method.
(2) A region with a size of 1 cm × 1 cm was selected at the middle of the silicon nitride membrane on one side, the silicon nitride membrane at this region was removed by use of photolithography and plasma etching for 4 minutes, which was used as the initial position for making the through hole 110 in the top chip 100.
(3) The Si wafer was etched from the above selected initial position by a potassium hydroxide wet process until the silicon nitride membrane on the other side was exposed, in this way, the through hole 110 was formed, while the remaining silicon nitride membrane covering the surface of the Si wafer was the first insulating film 510 and the second insulating film 520.
   It is worth noting that during the etching of the Si wafer, the formed through hole 110 was a groove with four edges, that is, the cross-sectional shape of the through hole 110 was a trapezoidal shape, so that the through hole 110 had two openings with different sizes; wherein, the silicon nitride membrane covering the smaller opening of the through hole 110 and the surface of the top chip 100 extending towards both sides of the opening was the first insulating film 510, and the silicon nitride membrane covering the other surface of the top chip 100 was the second insulating film 520. During the subsequent assembly of the top chip 100 and the bottom chip 200, the first insulating film 510 faced the bottom chip 200, that is, the first insulating film 510 essentially covered the inner surface of the top chip 100 and the opening of the through hole 110 on the inner surface of the top chip 100, and the second insulating film 520 covered the top surface of the top chip 100.
(4) Metal Au with a thickness of 50 nm was deposited on the first insulating film 510 between the lower end of the through hole 110 and the side end of the top chip 100 by using an electron beam evaporation method to form the first electrode 310 and the first electrode extending portion 311, and in the deposition process, the grid structure formed by photolithography at a place opposite to the through hole 110 allowed the first electrode 310 located under the through hole 110 to have a grid structure, and the metal Au deposited by extending the first electrode 310 towards the side end of the top chip 100 was the first electrode extending portion 311. It is worth noting that the first electrode 310 and the first electrode extending portion 311 were formed on the surface of the first insulating film 510 towards the bottom chip 200.
   Then, the preparation of the bottom chip 200 specifically adopts the following method.
(5) Another Si wafer having a thickness of 200 µm was selected as the material of the bottom chip 200 and a silicon nitride membrane (the stress of the silicon nitride membrane was about 250 MPa) with a thickness of 50 nm was grown on the opposite two sides of the Si wafer by chemical vapor deposition method.
(6) The Si wafer was etched by the potassium hydroxide wet etching process until a groove with four edges having an opening size of 1 cm × 1 cm was formed as the groove 210 of the bottom chip 200, wherein the etching depth was controlled to be about 100 µm, i.e., the depth of the groove 210 was about 100 µm. In this way, the silicon nitride membrane on both sides of the Si wafer except for the groove 210 was the third insulating film 530.
(7) A silicon nitride membrane with a thickness of 50 nm was grown on the inner wall of the groove 210 and the third insulating film 530 on both sides of the groove 210 by the chemical vapor deposition method as the fourth insulating film 540. That is, the fourth insulating film 540 was arranged oppositely with respect to the first insulating film 510.
(8) Metal Cu with a thickness of 50 nm was deposited on the fourth insulating film 540 on the inner surface of the bottom chip 200 by the electron beam evaporation method to form the second electrode 320, wherein the second electrode 320 and the first electrode 310 were not at the positions opposite to each other. That is, the second electrode 320 was actually located on the fourth insulating film 540 on one side of the groove 210.

It is worth noting that during the etching of the top chip 100 to make the through hole 110 and the etching of the bottom chip 200 to make the groove 210, the etching could be completed automatically by calculating the size of the initial etching position of the through hole 110 and the size of the etched opening of the groove 210 in advance, and then considering the thickness of the Si wafer used for the top chip 100 and the bottom chip 200, thereby forming the through hole 110 and the groove 210 with a predetermined size. That is, the sizes of the through hole 110 and the groove 210 were related to the size of the initial etching position and the size of the etched opening, respectively. Meanwhile, the factors such as the thickness and the stress of the first insulating film 510 consisted of silicon nitride membrane located at the opening on one side of the through hole 110 also affected the design of the through hole 110. The general method for designing the size of the through hole 110 and the groove 210 comprises: first, determining the sizes of the regions at which the through hole 110 and groove 210 are etched and the thicknesses of the Si wafers selected for the top chip 100 and the bottom chip 200; then etching along the crystal orientation, such that the through hole 110 and the groove 210 with a predetermined size are formed.

The size of the top chip 100 and bottom chip 200 prepared as described above were both 2 cm × 3 cm.

Finally, the to-be-tested solid sample 620 was adhered to the grid structure of the first electrode 310, the to-be-tested liquid 610 was placed in the groove 210 of the bottom chip 200, and two opposite ends of the top chip 100 and the bottom chip 200 were bonded by using an epoxy resin as an adhesive to form the first adhesive member 410 and the second adhesive member 420; specifically, the first adhesive member 410 was disposed between the second electrode 320 and the first insulating film 510 opposite thereto, and the second adhesive member 420 was disposed between the first electrode extending portion 311 and the fourth insulating film 540 opposite thereto; in this way, the to-be-tested solid sample 620 and the to-be-tested liquid sample 610 were packaged in the enclosed cavity formed of the top chip 100, the bottom chip 200, the first adhesive member 410 and the second adhesive member 420, and then the first electrode 310 and the second electrode 320 could be guided out through a conventional SEM hot stage and subjected to the in-situ SEM observation of the electrochemical reaction on the solid-liquid interface.

The chips for in-situ observation of the electrochemical reaction on solid-liquid interfaces prepared by the above preparation method are used in the in-situ SEM test without the use of expensive specially-made sample holder, therefore the cost is significantly reduced. Meanwhile, the grid structure of the first electrode 310 disposed under the through hole 110 facilitates the observation of the change of the to-be-tested sample.

While the present disclosure has been shown and described with reference to specific embodiments, it will be understood by those skilled in the art that various changes in the form and details may be made herein without departing from the scope of the present invention as defined by the appended claims.

## Claims

1. A chip assembly for *in-situ* observation of an electrochemical reaction on a solid-liquid interface, wherein it comprises a first electrode (310), a second electrode (320), a first insulating film (510), a second insulating film (520), a third insulating film (530), a fourth insulating film (540) as well as a top chip (100) and a bottom chip (200) which are oppositely arranged and of which two sides are correspondingly combined in a sealing manner;
the top chip (100) has a through hole (110), the first insulating film (510) covers the inner surface of the top chip (100) and an opening of the through hole (110) on the inner surface of the top chip (100), and the second insulating film (520) covers the outer surface of the top chip (100);
the first electrode (310) is disposed on the surface of the first insulating film (510) towards the bottom chip (200) and located under the through hole (110);
a part of the inner surface of the bottom chip (200) is recessed to form a groove (210) opposite to the through hole (110), the third insulating film (530) covers the inner surface and the outer surface of the bottom chip (200), and the fourth insulating film (540) covers the inner wall of the groove (210) and the third insulating film (530) on the inner surface of the bottom chip (200);
and the second electrode (320) is disposed on the fourth insulating film (540) and located on one side of the groove (210).

2. The chip assembly according to claim 1, wherein the size of the through hole (110) is gradually increasing in a direction away from the inner surface of the top chip (100).

3. The chip assembly according to claim 1, wherein the first electrode (310) has a grid structure.

4. The chip assembly according to claim 3, wherein the size of the first electrode (310) matches with the opening of the through hole (110) on the inner surface of the top chip (100).

5. The chip assembly according to claim 3, wherein the first electrode (310) extends towards the side end of the top chip (100) to form a first electrode extending portion (311).

6. The chip assembly according to claim 5, wherein the chip assembly further comprises a first adhesive member (410) and a second adhesive member (420), the first adhesive member (410) is disposed between the second electrode (320) and the first insulating film (510) opposite to the second electrode (320), and the second adhesive member (420) is disposed between the first electrode extending portion (311) and the fourth insulating film (540) opposite to the first electrode extending portion (311).

7. The chip assembly according to claim 6, wherein the first adhesive member (410) and/or the second adhesive member (420) are adhesives formed of epoxy resin.

8. The chip assembly according to claim 2, wherein the first electrode (310) has a grid structure.

9. The chip assembly according to claim 8, wherein the size of the first electrode (310) matches with the opening of the through hole (110) on the inner surface of the top chip (100).

10. The chip assembly according to claim 8, wherein the first electrode (310) extends towards the side end of the top chip (100) to form a first electrode extending portion (311).

11. The chip assembly according to claim 10, wherein the chip assembly further comprises a first adhesive member (410) and a second adhesive member (420), the first adhesive member is disposed between the second electrode (320) and the first insulating film (510) opposite to the second electrode (320), and the second adhesive member is disposed between the first electrode extending portion (311) and the fourth insulating film (540) opposite to the first electrode extending portion (311).

12. The chip assembly according to claim 11, wherein the first adhesive member (410) and/or the second adhesive member (420) are adhesives formed of epoxy resin.

13. The chip assembly according to claim 1, wherein the first insulating film (510) and/or the second insulating film (520) and/or the third insulating film (530) and/or the fourth insulating film (540) are formed of silicon nitride.

14. The chip assembly according to claim 1, wherein the material of the first electrode (310) and/or the second electrode (320) is conductive metal.

15. The chip assembly according to claim 1, wherein the sizes of the top chip (100) and the bottom chip (200) are from 1.5 cm × 2 cm to 2 cm × 3 cm.

## Patentansprüche

1. Eine Chip- Anordnung zur *In-situ* - Messung einer elektrochemischen Reaktion auf einer Fest- Flüssig- Phasenschnittstelle, umfassend eine erste Elektrode (310), eine zweite Elektrode (320), einen ersten Isolierfilm (510), einen zweiten Isolierfilm (520), einen dritten Isolierfilm (530) und einen vierten Isolierfilm (540) und außerdem einen oberen Chip (100) und einen unteren Chip (200), die einander gegenüberliegend angeordnet ist und von denen zwei Seiten dicht miteinander verbunden sind;
im oberen Chip (100) ist ein Durchgangsloch (110) vorgesehen, der erste Isolierfilm (510) bedeckt die Innenfläche des oberen Chips (100) und eine Öffnung des Durchgangslochs (110) auf der Innenfläche des oberen Chips (100) und der zweite Isolierfilm (520) bedeckt die Außenfläche des oberen Chips (100);
die erste Elektrode (310) ist vorgesehen an der Oberfläche des ersten Isolierfilms (510) zum unteren Chip (200) hin und befindet sich unter dem Durchgangsloch (110);
ein Teil der Innenfläche des unteren Chips (200) ist vertieft und bildet eine Nut (210), die dem Durchgangsloch (110) gegenüberliegt, der dritte Isolierfilm (530) bedeckt die Innenfläche und die Außenfläche des unteren Chips (200), und der vierte Isolierfilm (540) bedeckt die Innenwand der Nut (210) und den dritten Isolierfilm (530) auf der Innenfläche des unteren Chips (200);
und die zweite Elektrode (320) ist auf dem vierten Isolierfilm (540) angeordnet und auf einer Seite der Nut (210) positioniert.

2. Chip- Anordnung gemäß Anspruch 1, wobei die Größe des Durchgangslochs (110) sich nach und nach in Richtung weg von der Innenfläche des oberen Chips (100) vergrößert.

3. Chip- Anordnung gemäß Anspruch 1, wobei die erste Elektrode (310) eine Gitterstruktur hat.

4. Chip- Anordnung gemäß Anspruch 3, wobei die Größe der ersten Elektrode zur Öffnung des Durchgangslochs (110) auf der Innenfläche des oberen Chips (100) passt.

5. Chip- Anordnung gemäß Anspruch 3, wobei sich die erste Elektrode (310) zum seitlichen Ende des oberen Chips (100) erstreckt, um einen ersten Elektroden-Erweiterungsabschnitt (311) zu bilden.

6. Chip- Anordnung gemäß Anspruch 5, wobei die Chip- Anordnung weiterhin ein erstes adhäsives Element (410) und ein zweites adhäsives Element (420) enthält, das erste adhäsive Element (410) ist zwischen der zweiten Elektrode (320) und dem ersten Isolierfilm (510) angeordnet, gegenüber der zweiten Elektrode (320), und das zweite adhäsive Element (420) ist angeordnet zwischen dem ersten Elektroden-Erweiterungsabschnitt (311) und dem vierten Isolierfilm (540) gegenüber dem ersten Elektroden- Erweiterungsabschnitt (311).

7. Chip- Anordnung gemäß Anspruch 6, wobei das erste adhäsive Element (410) und/ oder das zweite adhäsive Element (420) Haftmittel aus Epoxidharz sind.

8. Chip- Anordnung gemäß Anspruch 2, wobei die erste Elektrode (310) eine Gitterstruktur hat.

9. Chip- Anordnung gemäß Anspruch 8, wobei die Größe der ersten Elektrode (310) zur Öffnung des Durchgangslochs (110) auf der Innenfläche des oberen Chips (100) passt.

10. Chip- Anordnung gemäß Anspruch 8, wobei sich die erste Elektrode (310) zum seitlichen Ende des oberen Chips (100) erstreckt, um einen ersten Elektroden-Erweiterungsabschnitt zu bilden (311).

11. Chip- Anordnung gemäß Anspruch 10, wobei die Chip- Anordnung weiterhin ein erstes adhäsives Element (410) und ein zweites adhäsives Element (420) enthält, das erste adhäsive Element (410) ist zwischen der zweiten Elektrode (320) und dem ersten Isolierfilm (510) angeordnet, gegenüber der zweiten Elektrode (320), und das zweite adhäsive Element ist angeordnet zwischen dem ersten Elektroden-Erweiterungsabschnitt (311) und dem vierten Isolierfilm (540) gegenüber dem ersten Elektroden- Erweiterungsabschnitt (311).

12. Chip- Anordnung gemäß Anspruch 11, wobei das erste adhäsive Element (410) und/ oder das zweite adhäsive Element (420) Haftmittel aus Epoxidharz sind.

13. Chip- Anordnung gemäß Anspruch 1, wobei der erste Isolierfilm (510) und/ oder der zweite Isolierfilm (520) und/ oder der dritte Isolierfilm (530) und/ oder der vierte Isolierfilm (540) aus Siliziumnitrid gebildet sind.

14. Chip- Anordnung gemäß Anspruch 1, wobei das Material der ersten Elektrode (310) und/ oder der zweiten Elektrode (320) ein leitendes Metall ist.

15. Chip- Anordnung gemäß Anspruch 1, wobei die Größen des oberen Chips (100) und des unteren Chips (200) zwischen 1.5 cm x 2 cm und 2 cm x 3 cm liegen.

## Revendications

1. Ensemble de puces pour une observation *in situ* d'une réaction électrochimique sur une interface solide-liquide, dans lequel il comprend une première électrode (310), une seconde électrode (320), un premier film isolant (510), un deuxième film isolant (520), un troisième film isolant (530), un quatrième film isolant (540) ainsi qu'une puce supérieure (100) et une puce inférieure (200) qui sont agencées de façon opposée et dont deux côtés sont combinés de manière correspondante d'une manière étanche ;
la puce supérieure (100) a un trou traversant (110), le premier film isolant (510) recouvre la surface intérieure de la puce supérieure (100) et une ouverture du trou traversant (110) sur la surface intérieure de la puce supérieure (100), et le deuxième film isolant (520) recouvre la surface extérieure de la puce supérieure (100) ;
la première électrode (310) est agencée sur la surface du premier film isolant (510) vers la puce inférieure (200) et située sous le trou traversant (110) ;
une partie de la surface intérieure de la puce inférieure (200) est évidée pour former une rainure (210) opposée au trou traversant (110), le troisième film isolant (530) recouvre la surface intérieure et la surface extérieure de la puce inférieure (200), et le quatrième film isolant (540) recouvre la paroi intérieure de la rainure (210) et le troisième film isolant (530) sur la surface intérieure de la puce inférieure (200) ;
et la seconde électrode (320) est disposée sur le quatrième film isolant (540) et située sur un côté de la rainure (210).

2. Ensemble de puces selon la revendication 1, dans lequel la taille du trou traversant (110) augmente progressivement dans une direction s'éloignant de la surface intérieure de la puce supérieure (100).

3. Ensemble de puces selon la revendication 1, dans lequel la première électrode (310) a une structure en grille.

4. Ensemble de puces selon la revendication 3, dans lequel la taille de la première électrode (310) correspond à l'ouverture du trou traversant (110) sur la surface intérieure de la puce supérieure (100).

5. Ensemble de puces selon la revendication 3, dans lequel la première électrode (310) s'étend vers l'extrémité latérale de la puce supérieure (100) pour former une première partie d'extension d'électrode (311).

6. Ensemble de puces selon la revendication 5, dans lequel l'ensemble de puces comprend en outre un premier élément adhésif (410) et un second élément adhésif (420), le premier élément adhésif (410) est disposé entre la seconde électrode (320) et le premier film isolant (510) opposé à la seconde électrode (320), et le second élément adhésif (420) est disposé entre la première partie d'extension d'électrode (311) et le quatrième film isolant (540) opposé à la première partie d'extension d'électrode (311).

7. Ensemble de puces selon la revendication 6, dans lequel le premier élément adhésif (410) et/ou le second élément adhésif (420) sont des adhésifs formés de résine époxy.

8. Ensemble de puces selon la revendication 2, dans lequel la première électrode (310) a une structure en grille.

9. Ensemble de puces selon la revendication 8, dans lequel la taille de la première électrode (310) correspond à l'ouverture du trou traversant (110) sur la surface intérieure de la puce supérieure (100).

10. Ensemble de puces selon la revendication 8, dans lequel la première électrode (310) s'étend vers l'extrémité latérale de la puce supérieure (100) pour former une première partie d'extension d'électrode (311).

11. Ensemble de puces selon la revendication 10, dans lequel l'ensemble de puces comprend en outre un premier élément adhésif (410) et un second élément adhésif (420), le premier élément adhésif est agencé entre la seconde électrode (320) et le premier film isolant (510) opposé à la seconde électrode (320), et le second élément adhésif est agencé entre la première partie d'extension d'électrode (311) et le quatrième film isolant (540) opposé à la première partie d'extension d'électrode (311).

12. Ensemble de puces selon la revendication 11, dans lequel le premier élément adhésif (410) et/ou le second élément adhésif (420) sont des adhésifs formés de résine époxy.

13. Ensemble de puces selon la revendication 1, dans lequel le premier film isolant (510) et/ou le deuxième film isolant (520) et/ou le troisième film isolant (530) et/ou le quatrième film isolant (540) sont formés de nitrure de silicium.

14. Ensemble de puces selon la revendication 1, dans lequel le matériau de la première électrode (310) et/ou de la seconde électrode (320) est un métal conducteur.

15. Ensemble de puces selon la revendication 1, dans lequel les tailles de la puce supérieure (100) et de la puce inférieure (200) sont de 1,5 cm x 2 cm à 2 cm x 3 cm.
